# EUROPEAN PATENT SPECIFICATION

(11) **EP 3 477 647 B1**
(45) Date of publication and mention of the grant of the patent: **27.04.2022**
(21) Application number: 17001784.2
(22) Date of filing: 27.10.2017
(51) Int. Cl.: G11C 29/08, G11C 11/16, G11C 8/14, G11C 8/08

(54) **EFFICIENT TESTING OF A MAGNETIC MEMORY CIRCUIT**
EFFIZIENTE PRÜFUNG EINES MAGNETISCHEN SPEICHERS
TEST EFFICACE D'UNE MÉMOIRE MAGNÉTIQUE

(43) Date of publication of application: 01.05.2019
(73) Proprietor: Karlsruher Institut für Technologie, 76131 Karlsruhe (DE)
(72) Inventor: Oboril, Fabian, 76139 Karlsruhe (DE); Bishnoi, Rajendra, 76676 Graben-Neudorf (DE); Tahoori, Mehdi, 76139 Karlsruhe (DE)
(74) Representative: Müller-Boré & Partner Patentanwälte PartG mbB

(56) References cited:
- US-A1- 2013 301 335

## Description

### Technical Field

The following description relates to a memory circuit based on spin orbit torque (SOT) technology that enables fast testing by performing read and write operations in parallel.

### Background

New developments in technology have seen the emergence of systems-on-a-chip (SoCs), i.e. integrated circuits comprising all necessary components, including memory, for autonomously functioning as a computer, namely without requiring other chips. However, with technology downscaling, the traditional memory technologies, such as static random-access memory (SRAM) and dynamic random-access memory (DRAM), are facing severe challenges due to leakage currents. The reason is that static power is consumed via leakage currents and the smaller the size of the transistors, the more significant the static power consumption.

Therefore, emerging spintronic technology, in particular SOT technology, is gaining popularity because of its several attractive features such as high scalability, zero leakage for bit cells, high endurance, small size, faster accesses, immunity to soft-error due to radiation, compatibility with CMOS, etc. However, due to new fabrication processes and the magnetic materials, SOT-based magnetic random-access memory (SOT-MRAM) is facing severe testing challenges. For instance, it is hard to identify those devices that are non-defective, but nonetheless present a slight deviation from their nominal characteristics. To determine whether such deviations are present, the bit-cell array of the memory has to be accessed several times in the testing phase. Hence, it is fundamental to address the testing-time-related issues by having a fast testing method for spintronic-based memories.

US 2013/301335 A1 discloses a method for massive parallel stress testing of resistive type memories. The method can include, for example, disabling one or more internal analog voltage generators, configuring memory circuitry to use a common plane voltage (VCP) pad or external pin, connecting bit lines of the memory device to a constant current driver, which works in tandem with the VCP pad or external pin to perform massive parallel read or write operations. The data can be retention tested or otherwise verified using similar massive parallel testing techniques. Embodiments also include a memory test system including a memory device having DFT circuitry configured to perform massive parallel stress testing, retention testing, functional testing, and test setup and initialization.

### Summary

It is an object of the invention to provide a memory circuit that allows for an increase in the speed of the memory test operations specifically for spintronic-based memories, without affecting the normal operations thereof. In other words, the goal of the invention is to make memory test operations more efficient timewise, specifically in view of the requirements of the latest technology.

The achievement of this object in accordance with the invention is set out in the independent claims. Further developments of the invention are the subject matter of the dependent claims.

According to a first aspect a memory circuit is provided being configured to increase the speed of memory test operations, the memory circuit comprising:
at least one bit cell comprising a magnetic tunnel junction including two ferromagnetic layers and a metal electrode and comprising three electronic switches , wherein: one ferromagnetic layer has a fixed magnetic orientation and the other ferromagnetic layer has a changeable magnetic orientation that is configured to be changed by a current flow through the metal electrode; and the three electronic switches comprise a write access electronic switch configured to control the access to the bit cell during write operations,
a read access electronic switch configured to control the access to the bit cell during read operations and a read-and-write access electronic switch configured to control the access to the bit cell during both read and write operations; and at least one logic circuit comprising three control pins, each pin configured to receive a single input signal, and a plurality of output pins, each output pin connected to a corresponding electronic switch of the three electronic switches, wherein one of the three control pins is a test pin configured to enable or disable simultaneous read and write operations on the at least one bit cell, wherein simultaneous read and write operations are configured to be performed in the same clock cycle and the read access is faster than the write access so that the read operation reads a bit value stored in the at least one bit cell by a previous write operation and not the bit value that is being written by the simultaneous write operation.

A bit cell is the part of a circuit in which a single bit is recorded. A bit is a unit of data that can have only one of the two values of a binary state, which are in the following also referred to as "complementary values". Usually these values are denoted with 0 and 1: 0 is the complementary value of 1 and 1 is the complementary value of 0. Therefore, a bit value can be either 0 or 1 and, respectively, the complementary bit value will be 1 or 0. Recording a bit in a bit cell means storing the bit value in the bit cell. The memory circuit may comprise more than one bit cell, i.e. a plurality of bit cells.

A magnetic tunnel junction (MTJ) is a component consisting of two ferromagnetic layers separated by a thin insulator (such as an oxide layer). According to quantum mechanics, electrons can tunnel from one ferromagnetic layer into the other. If the magnetizations of the two layers are in a parallel orientation (P magnetization state) it is more likely that electrons will tunnel through the insulator than if they are in the antiparallel orientation (AP magnetization state). One ferromagnetic layer (also called reference layer) has a fixed magnetic orientation and the other ferromagnetic layer (also called free layer) has a changeable magnetic orientation, so that the cell can be brought into a P magnetization state or an AP magnetization state. Consequently, an MTJ can be switched between two states of electrical resistance, one with low and one with very high resistance. The magnetization direction in the MTJs may be used for bit storage, wherein '0' and '1' correspond to parallel and antiparallel magnetizations in the MTJ, respectively. MTJs are well known to the skilled person in this technical field.

In order to change the magnetization of the ferromagnetic layer with changeable magnetic orientation, a current flows through the metal electrode. The magnetization of the free layer varies based on the direction of the write current. For example, it may be a spin-polarized current in order to exploit the SOT effect. In light of what has been explained, an SOT-MTJ can be used as the storing device of a bit cell.

An SOT-MTJ has three terminals, out of which two are write terminals and one is a read terminal. The read is performed by passing a low current through the read terminal and one of the write terminals. To write a value, a write current that flows between the two write terminals through a metal electrode is used, wherein the metal electrode generates a torque on the magnetization of the free layer. If the bit value to be written to the bit cell is different from the bit value currently stored in the bit cell, the magnetization of the free layer is changed. If the bit value to be written to the bit cell is the same as the bit value currently stored in the bit cell, the magnetization of the free layer remains the same.

The bit cell comprises the SOT-MTJ as storing device and further comprises three electronic switches configured to control access to the storing device via its terminals, in particular there is one electronic switch for each terminal. An electronic switch has an "on" state, in which current can flow through the switch, and an "off" state, in which current cannot flow through the switch. An example of an electronic switch is a transistor. Controlling the access means that the electronic switch allows a read or write operation to be actually performed on the bit cell or prevents a read or write operation from being performed. Indeed, read and write operations are performed by means of currents passing through the bit cell and only when the electronic switches are in an "on" state the read or write current can flow through and reach the storing device.

One of the electronic switches is a write access electronic switch, in that it controls the access to the bit cell during write operations. The write access electronic switch is connected to one of the write terminals of the SOT-MTJ and enables write operations, i.e. operations in which current flows through the metal electrode so that the magnetization of the free layer may be changed, when it is in an "on" state. In other words, the write access electronic switch must be on during write operations in order for a bit value to be written to the bit cell.

Another one of the electronic switches is a read access electronic switch, in that it controls the access to the bit cell during read operations. The read access electronic switch is connected to the read terminal of the SOT-MTJ and enables read operations, i.e. operations in which a bit value stored in the bit cell is read, when it is in an "on" state. In other words, the read access electronic switch must be on during read operations in order for a bit value to be read from the bit cell.

The third electronic switch is a read-and-write access electronic switch, in that it controls the access to the bit cell during both read and write operations. The read-and-write access electronic switch is connected to the write terminal of the SOT-MTJ that is not connected to the write access electronic switch. The read-and-write access electronic switch enables both read and write operations when it is in an "on" state. In other words, the read-and-write access electronic switch must be on during both read and write operations in order to allow the current to flow along the necessary paths.

To summarize, when a read operation has to be carried out, both the read access electronic switch and the read-and-write access electronic switch must be on. When a write operation has to be carried out, both the write access electronic switch and the read-and-write access electronic switch must be on.

The memory circuit further comprises at least one logic circuit that serves as control circuitry by regulating the access to the bit cell. In particular, as it will be explained in more detail below, the logic circuit allows the memory circuit to be in a different mode during testing, leading to a reduction in testing time, whereas when the memory circuit is in operation mode (i.e. not testing) the access times are unaffected.

The memory circuit may comprise more than one logic circuit, i.e. a plurality of logic circuits, when it comprises more than one bit cell. In particular, if the bit cells are arranged in a two-dimensional array comprising rows and columns, the memory circuit may comprise a number of logic circuits equal to the number of rows in the array.

The logic circuit comprises control pins and output pins, the pins being electrical connections used to transfer power and transmit information. Each of the control pins (hereinafter also referred to as input pins) receives a single input signal. The input signal is a data signal that transmits a bit, namely a logic signal. Thus, the information carried by the data signal comprises only one bit and nothing else. The logic signal is said to be in a level of logical high when the bit value is 1 and in a level of logical low when the bit value is 0.

The logic circuit has three control pins and three output pins. The signals transmitted to the three control pins are combined via logic gates in order to determine the signals, i.e. the bit values, that reach the output pins. A logic signal in a logical high level transmitted to a pin is said to "activate" the pin.

In a conventional SOT-MRAM architecture, the accessing mechanism to the one or more bit cells comprises at least one demultiplexer that has a word line (WL) signal as input, a write enable (WE) signal as selector input and two output signals, one that enables write operations and one that enables read operations.

According to the invention, this accessing mechanism is replaced by the logic circuit that has an extra input pin, i.e. the test pin, for receiving an additional input with respect to the WL signal and the WE signal. Further, the logic circuit has also three output pins to govern the three electronic switches, respectively. Specifically, the logic circuit has an output pin that can output a signal enabling write operations, an output pin that can output a signal enabling read operations and an output pin that can output a signal enabling read and write operations simultaneously. In the context of logic signals, this enabling usually implies that the bit carried by the signal has value 1. Indeed, when the output pin signal is in a logical high level as a result from the specific combination of the input signals due to the structure of the logic circuit, the corresponding electronic switch switches to or remains in an 'on' state. When the output pin is in a logical low level, the corresponding electronic switch switches to or remains in an 'off' state. As explained above, the 'on' state of the electronic switches enables the read and/or write operations.

The logic circuit is configured such that when and only when the test pin receives a logic signal in a logical high level, all output signals can be in a logical high level, thereby enabling simultaneous read and write operations. The test pin owes its name to the fact that it receives a logical high signal only during testing, so that read and write operations can be performed in parallel when testing the SOT-MRAM. Heretofore the convention was followed according to which 'on' states or activated states are associated with a level of logical high denoted with '1'. However, an inverted notation may also be used, meaning the level of logical high may correspond to a bit value of 0 and the level of logical low may correspond to a bit value of 1. The description of the memory circuit and its functioning would equally apply to this other notation by simply swapping the bit values.

In the conventional approach of testing, first a write operation is performed to store a bit value and subsequently a read operation is performed to extract the stored value, i.e. read and write operations are performed separately, one after another. According to the invention, read and write accesses can be performed simultaneously during testing, i.e. in testing mode, thereby significantly reducing the testing time.

The memory circuit according to the invention is explicitly designed and accordingly manufactured for optimizing the testing procedure. In particular, the design of the memory circuit includes the test pin that enables the memory circuit to be in two different modes: a testing mode and an operating mode. The constructional features and the operating principles of the memory circuit in the testing mode result in a more efficient testing thanks to the simultaneous reading and writing. It is a finding of this invention to provide a memory circuit that can be set to a testing mode in which simultaneous reading and writing is actually implemented.

Advantageously, the memory circuit as described can be easily integrated with existing environments for testing memories, such as memory built-in self-test (MBIST) environments, as it will be explained later with reference to the figures. Further, the overall methodology in terms of bit-cell accesses and input patterns entry is simplified in comparison to conventional methods. Indeed, in the conventional methodology, test data are stored in a bit cell and then the bit cell needs to be accessed again to read the stored data. Conversely, in the proposed approach, both read and write operations are performed at the same time, meaning that the bit cell is accessed only one time. In other words, the read operation happens on-the-fly during the write operation. Not only is the test methodology simplified, also all test accessories (read, write and comparison circuit components) are fully utilized during testing, unlike in the conventional case, where the read and comparator components are idle when the write operation is performed.

In a preferred embodiment, the memory circuit comprises a plurality of bit cells.

In a preferred embodiment a memory device may comprise the memory circuit as described above.

In a preferred embodiment, the memory device is usable as the random access memory of a computing device, such as a personal computer, a laptop computer, mobile phone, a tablet computer, or any such device.

In a further preferred embodiment, the memory device is part of a system on a chip.

Yet another embodiment relates to a use of the memory device as a memory in a computing device, wherein the memory circuit is in an operating mode in which the test pin is deactivated when used in the computing device.

In other words, during a testing phase the memory circuit is set to the testing mode by activating the test pin. Once it is established that the memory circuit is suitable to be used, the test pin is deactivated and the memory circuit is set to the operating mode, in which the memory circuit serves as a memory for storing data.

Another embodiment relates to a computing device comprising one or more memory devices as described above.

Yet another aspect of the present invention relates to a method for testing the magnetic tunnel junction based circuit described above. The method comprises:
- activating a test pin;
- writing a first reference value to at least one bit cell comprising three electronic switches;
- reading a first read bit value from the at least one bit cell;- comparing the first read bit value with the first reference value;
- writing a second reference value to the at least one bit cell;
- reading a second read bit value from the at least one bit cell;
- comparing the second read bit value with the second reference value;
- if there is a match between the first read bit value and the first reference value and a match between the second read bit value and the second reference value, determining that the at least one bit cell is faultless, or
- if there is not a match between the first read bit value and the first reference value or a match between the second read bit value and the second reference value, determining that the at least one bit cell is faulty;
wherein the three electronic switches comprise a write access electronic switch configured to control the access to the bit cell during write operations, a read access electronic switch configured to control the access to the bit cell during read operations and a read-and-write access electronic switch configured to control the access to the bit cell during both read and write operations, and wherein reading the first read bit value and writing the second reference value are performed simultaneously in that they are performed in the same clock cycle and the read access is faster than the write access so that the first read bit value is read while the first reference value, and not the second reference value that is being written simultaneously, is stored in the at least one bit cell.

Activating the test pin means sending to the test pin a logic signal at a high logical level, i.e. transmitting the bit value of 1. When the test pin is activated, the memory circuit is in the testing mode, in which the performance of the memory circuit is tested by checking that data (i.e. bit values) is stored and can be retrieved correctly. The test pin is not activated in operating mode, i.e. after testing has been completed and e.g. the memory circuit has become part of a computing device.

The first operation performed is an individual write operation, meaning that no read operation is performed at the same time. As explained, the write operation includes having a current flow between the two write terminals of the SOT-MTJ storing device of the bit cell. The direction of the current determines the value of the stored bit.

The first reference value written via the write operation may in some examples be stored in an external storage, i.e. a storage that is not part of the memory circuit, such as a storage part of a testing environment (e.g. MBIST).

After the first reference value has been written, the method exploits the simultaneous read and write capabilities of the memory circuit. Specifically, a read operation that tries to recover the first reference value and a write operation that writes a second reference value are performed simultaneously. As explained, since the read operation is much faster than the write operation, in this application it has been found that for testing the circuit there is no conflict between the two operations, and the read operation always reads the value that was written to the bit cell by a previous write operation and not by the concurrent write operation.

The read operation includes having a current flow between the read terminal and one of the two write terminals of the SOT-MTJ storing device. In particular, the read current follows the path of the write current once it passes through the thin insulator of the SOT-MTJ storing device, because of the three-terminal structure of the SOT-MTJ storing device, as explained in more detail below.

The first read bit value should correspond to the first reference value written previously to the bit cell, if the bit cell is not defective or otherwise not functioning correctly. Thus, the first read bit value is compared with the first reference value to check whether the two values match, i.e. are identical.

While the first reference value is being read, a second reference value is written to the bit cell. As already mentioned, also the second reference value may in some examples be stored in an external storage.

Afterwards, an individual read operation is performed, wherein the read operation attempts to read the second reference value now stored in the bit cell. The second read bit value is compared with the second reference value to check whether there is a match.

If both comparisons yield a match as a result, it is determined that the bit cell functions properly. If at least one of the two comparisons shows that the read value does not correspond to the bit value actually stored in the bit cell, the bit cell is faulty and cannot provide a memory functionality.

The testing method may comprise multiple checking steps, in the sense that checking whether a written value is correctly read may be performed more than two times.

For example, the method may further comprise:
- writing a third reference value to the at least one bit cell;
- reading a third read bit value from the at least one bit cell;
- comparing the third read bit value with the third reference value;

wherein reading the second read bit value and writing the third reference value are performed simultaneously,
wherein determining that the at least one bit cell is faultless further requires that there is a match between the third read bit value and the third reference value, and wherein determining that the at least one bit cell is faulty further occurs if there is not a match between the third read bit value and the third reference value.

In a more general way, the method may comprise a first individual write operation that writes a first reference value, a last individual read operation that reads an N-th read value and N - 1 simultaneous operations in between. In each simultaneous operation, an n-th read value is read and an (n+1)-th reference value is written, wherein n runs from 1 to N - 1. N and n are natural numbers.

All values that are read are compared with the corresponding reference value. The bit cell is considered faultless when all comparisons yield a match and considered faulty if at least one comparison indicates that the read value is different from the written value.

When the memory circuit comprises more than one bit cell, the testing method may further comprise selecting a memory address identifying the at least one bit cell among the plurality of bit cells.

According to an embodiment, the memory circuit is part of a chip, such as a SoC, and the method is carried out before the chip is installed in a computing device, such as a mobile device, that stores data in the memory circuit.

Another aspect of the present invention relates to a method for producing a memory circuit, the method comprising:
manufacturing the memory circuit by providing it with at least one bit cell and at least one logic circuit as described for the previous aspects; and
testing the memory circuit according to the method described above.

### Brief Description of the Drawings

Details of exemplary embodiments are set forth below with reference to the exemplary drawings. Other features will be apparent from the description, the drawings, and from the claims. It should be understood, however, that even though embodiments are separately described, single features of different embodiments may be combined to further embodiments.
Figure 1 shows a block diagram representation of a memory built-in self-test circuitry according to the prior art.
Figure 2 shows a flow chart of a memory testing method according to the prior art.
Figure 3 shows a spin-orbit-torque magnetic-tunnel-junction storing device for a bit cell and a bit cell comprising such storing device according to the prior art.
Figure 4 shows a spin-orbit-torque magnetic RAM architecture according to the prior art.
Figure 5 shows an example of a bit cell enabling simultaneous read and write operations.
Figure 6 shows different examples of a logic circuit that controls access to a bit cell enabling simultaneous read and write operations during testing.
Figure 7 shows a spin-orbit-torque magnetic RAM architecture that enables simultaneous read and write operations during testing.
Figure 8 shows a flow chart of a memory testing method in which read and write operations are performed simultaneously.
Figure 9 shows the memory read/write operations and the comparison operation with respect to a clock period.

### Detailed Description

In the following, a detailed description of examples will be given with reference to the drawings. It should be understood that various modifications to the examples may be made. Unless explicitly indicated otherwise, elements of one example may be combined and used in other examples to form new examples.

In general, a memory is tested by performing first a sequence of operations that write a known pattern of bits to the bit cells in the memory, and then reading the same to validate the stored data. This can be accomplished in two ways, namely either by using external testers or by using built-in self-test circuitry.

Test operations by means of an external tester are time consuming and they require a connection to the ports of the memory, which, in the case of embedded memories, are not directly accessible. Therefore, embedded memories typically have a memory built-in self-test (MBIST) circuitry for testing, which provides a mechanism to test an embedded memory without the need of an external evaluation method.

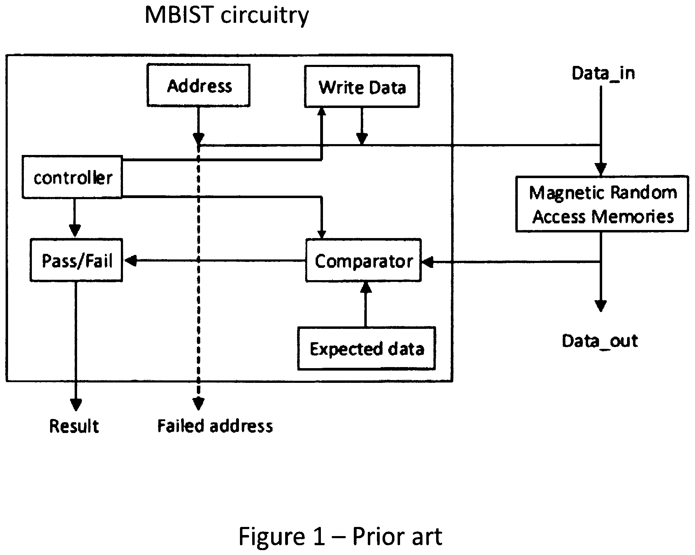

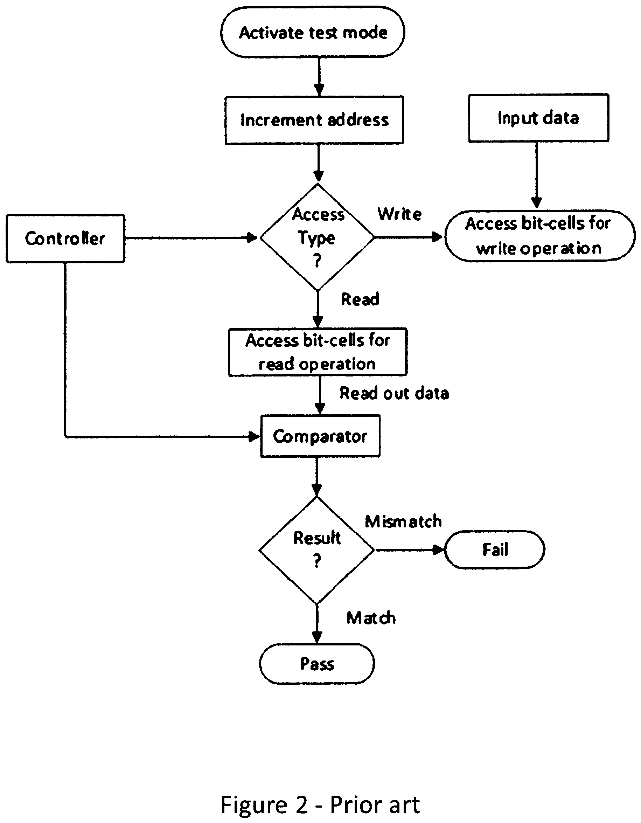

The block diagram of a basic MBIST circuitry as known in the art is shown in **Figure 1** and the testing method performed via the MBIST is described using a flowchart as shown in **Figure 2****.**

The MRAM has a number of addresses that are iteratively tested. The MBIST circuitry interfaces itself with the MRAM via its ports. The MBIST circuitry performs the same write, read and check operations for each memory address, which is determined prior to the operations and sequenced incrementally to range from the minimum address to the maximum address in the memory space. It is of course also possible to proceed according to a decreasing address order. Once the address has been selected, the controller determines which operation needs to be performed, namely a write or a read operation, and that operation is carried out for all bit cells according to the increasing or decreasing address order.

The first operation performed for each given address is writing input data, i.e. a bit value, to the bit cell corresponding to that address, wherein the bit value is also saved as expected data within the MBIST circuitry. Once the bit value has been stored in the bit cell, the bit cell is accessed for a read operation. The read value is then compared with the reference value of the expected data, which corresponds to the originally written value, by a comparator module under control of the controller. If there is a mismatch between the read value and the written value, the MBIST detects a failure in the bit cell, which indicates a malfunctioning of the bit cell and, thus, of the memory. If there is a match between the read value and the written value, the MBIST determines that the bit cell functions correctly.

The finite sequence of read and write operations applied to every bit cell in the memory is called a march element and a memory test is also called a march test, since it consists of a series of march elements. An example of a pattern of bit values, i.e. of 0's and 1's, that is used in a march test is the March-C pattern, illustrated in the table below:

**Table 1: March-C pattern**

| Step | Operation | Address |
|---|---|---|
| 1 | W0 | ⇕ |
| 2 | R0; W1 | ⇑ |
| 3 | R1; W0 | ⇑ |
| 4 | R0 W1 | ⇓ |
| 5 | R1; W0 | ⇓ |
| 6 | R0 | ⇕ |

The notation for the above table is that RX indicates a read operation in which the bit value X is read, WX indicates a write operation in which the bit value X is written, the up arrow indicates that the addresses are sequenced incrementally from the minimum address to the maximum address in the memory space, the down arrow indicates that the addresses are sequenced in a decremental manner, and the bidirectional arrow indicates either an increasing or a decreasing addressing sequence. A semicolon separates operations that occur simultaneously in the same clock cycle.

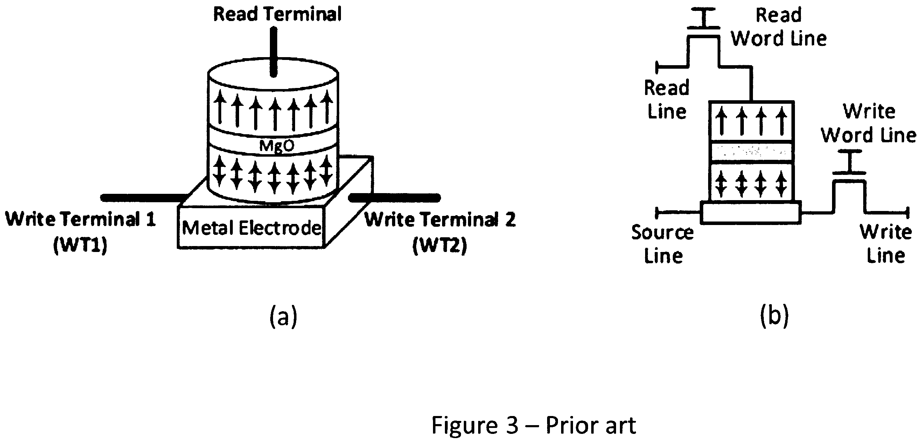

The above-described standard testing method is applied for standard SOT-MRAMs based on SOT-MTJ bit cells as shown in **Figure 3****.** Specifically, view (a) of Figure 3 shows an SOT-MTJ storing device and view (b) of Figure 3 shows the bit cell, which comprises the storing device and access transistors.

The SOT-MTJ as shown in Figure 3(a) is a three terminal storing device, out of which two are write terminals and one is a read terminal. As explained, a bit value is stored in the SOT-MTJ in the form of a resistance state influenced by the two ferromagnetic layers. Out of these two layers, one has always fixed magnetization (reference layer) and the other one (free layer) has a magnetization varying based on the direction of the write current. The read is performed by passing a low current through the read terminal and one of the write terminals. To write a value, the magnetic orientation of the free layer is changed to either a parallel or an antiparallel configuration, using a write current that flows between the two write terminals through the metal electrode. For instance, if the write current flows from 'WT1' to 'WT2', it leads to an 'AP' state switching and vice versa.

The bit cell as depicted in Figure 3(b) comprises the terminal storing device and two access transistor, namely a write access transistor and a read access transistor, for a total of five terminals. During read and write operations, the corresponding access transistor is set to an 'on' state by activating the respective word line, i.e. by transmitting through the word line a logic signal in a high logical level. A memory usually comprises a two-dimensional array of bit cells, whose rows are connected by means of word lines and whose columns are connected via bit lines. In other words, the gates of the transistors of all bit cells in a certain row of the array are connected by a word line, which can accordingly open or close the transistor of a given bit cell. The transistor is turned on for the bit cell that is required to be accessed. The bit lines instead connect the source/drain of the transistors of all bit cells in a certain column of the array, so that the bit lines are responsible for actually performing the read and write operations. Both word lines and bit lines are usually metallic stripes to which a high voltage (e.g. higher than 2.6 V) is applied to transmit a logic signal carrying a '1' and a low voltage (e.g. lower than 0.4 V) is applied to transmit a logic signal carrying a '0'. In an alternative embodiment, the high voltage for the logic signal '1' is approximately 1V and the low voltage for the logic signal '0' is approximately 0V. These exemplary voltages apply for example for 40nm/65nm technology nodes. The read and write currents flow through the bit lines and the value is stored based on the direction of the current, whereas the value is read based on the resistance state of the storing device.

Indeed Figure 3(b) shows three bit lines, namely the read line, the source line and the write line. The read current flows through the read line to the source line and the write current, which has a bidirectional path, flows between the source line and the write line.

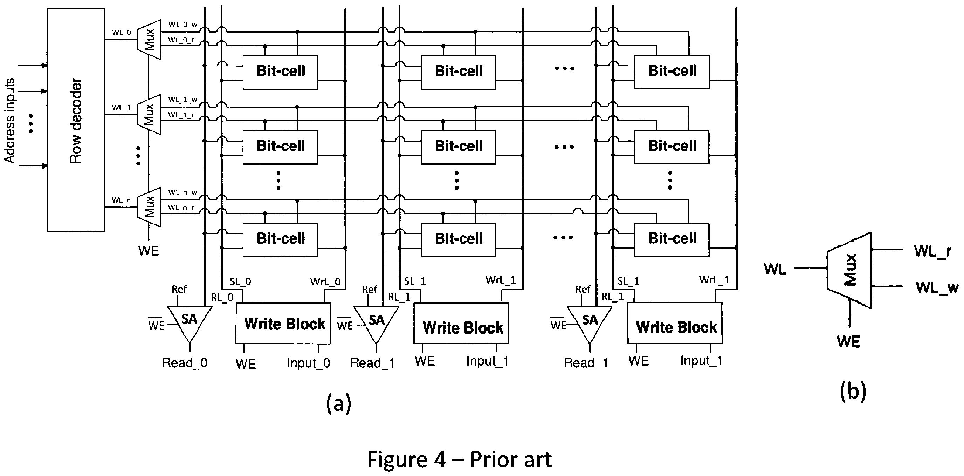

Such an array of bit cells forming a standard SOT-MRAM architecture is shown in **Figure 4****.** The architecture shown in view (a) comprises the array of bit cells in combination with a row decoder as well as read and write blocks. The row decoder is configured to access the respective bit cell for a given address. As explained before, the word lines are the input for a plurality of demultiplexers having a common WE signal as selector input. Each demultiplexer, as shown in view (b), has two output signals, one that enables write operations, WL_w, and one that enables read operations, WL_r. Looking also at Figure 3(b), it can be seen that the read word line coming out of demultiplexer can put the read access transistor in an 'on' state, whereas the write word line coming out of demultiplexer closes the write access transistor. The read and write blocks comprise sense amplifiers. Like any other memory architecture, this type of memory can be partitioned into several banks.

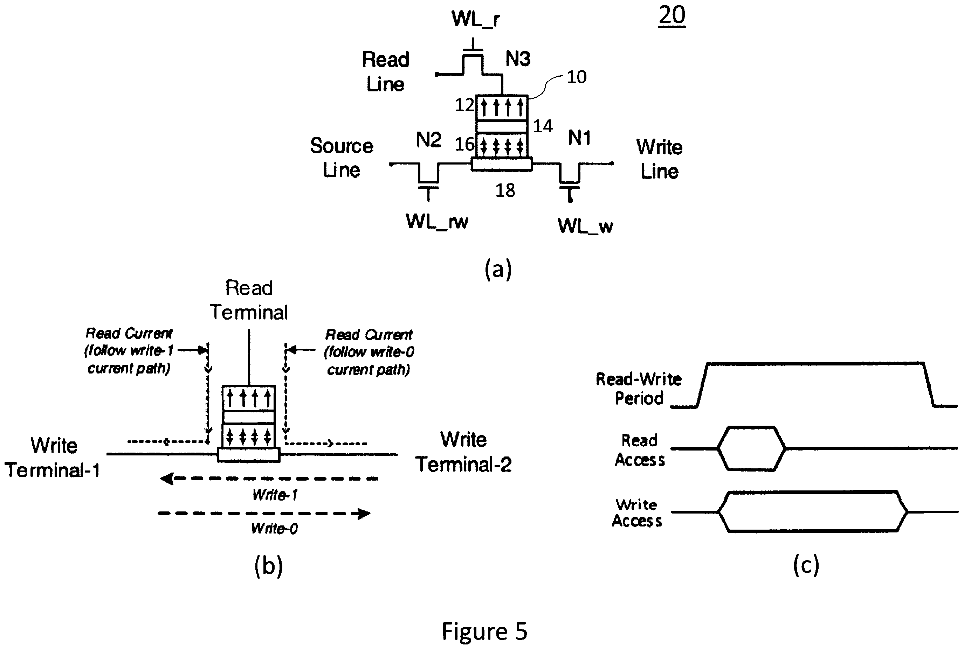

The conventional testing approach for an SOT-MRAM as illustrated with reference to Figures 1 and 2 is slow and time consuming. Since nowadays about 70% of the costs for the production of a memory arise from testing, it is desirable to reduce the testing time by improving the efficiency of the testing process. The testing time can be considerably reduced by the new approach that will be described with reference to Figures 5 to 9. In particular, the proposed testing method dismisses the core idea of the conventional method according to which write and read operations must be performed one after the other and exploits instead the features of SOT-MTJ storing devices by performing write and read operations simultaneously during testing.

In order to utilize the characteristics for simultaneous reading and writing of the SOT-MTJ storing device, the architecture of the bit cell shown in Figure 3(b) is modified to introduce additional accessibility. The modified bit cell for simultaneous reading and writing together with its functionality is shown in **Figure 5****.** View (a) of Figure 5 shows the architecture of the bit cell 20, which comprises the SOT-MTJ 10 including the reference layer 12, the barrier oxide layer 14, the free layer 16 and the metal electrode 18. The bit cell 20 further comprises three transistors N1, N2 and N3, wherein N1 is the write access transistor, N2 is the read-and-write access transistor and N3 is the read access transistor. In comparison to the bit cell of Figure 3(b), the additional transistor N2 has been connected to the source line.

The presence of the read-and-write access transistor N2 has two effects: it balances the write operation and it balances the read operation. With regard to the write operation, the read-and-write access transistor N2 eliminates the asymmetry in the write currents to write a '0' or a '1', thus balancing also the write latency. With regard to the read operation, the read-and-write access transistor N2 enables the bit cell to exploit the intrinsic symmetry of the SOT-MTJ storing device. Indeed, as shown in view (b) of Figure 5, the read current can pass through either of the two write terminals. In the modified bit cell, the read current is always directed in such a way that it follows along the corresponding write current, namely such that when a '0' is to be read, the read current follows the write-0 current path and when a '1' is to be read, the read current follows the write-1 current path. In other words, the conventional write current always flows from a high potential terminal to one at a low potential, and hence, the read current will also flow through the same path after passing through the barrier oxide layer 14.

View (c) of Figure 5 shows that the read access is significantly faster than the write access. Therefore, old data can always be read without any conflicts in the case of simultaneous read and write operations on the same bit cell. In other words, a read operation will always read the bit value stored by a previous write operation and not the bit value that is being written by the simultaneous write operation.

The read-and-write access transistor N2 must be in an 'on' state both for read and write operations. Hence, the read and write word lines are input in an OR gate whose output is then connected to the read-and-write access transistor N2, so that it is on when either the read or write word line or both are activated, as shown in the following table:

**Table 2: Operations in the modified bit cell.**

| Access transistors | | | Operations |
|---|---|---|---|
| N1 | N2 | N3 | |
| ON | ON | OFF | Write only |
| OFF | ON | ON | Read only |
| ON | ON | ON | Read and write |

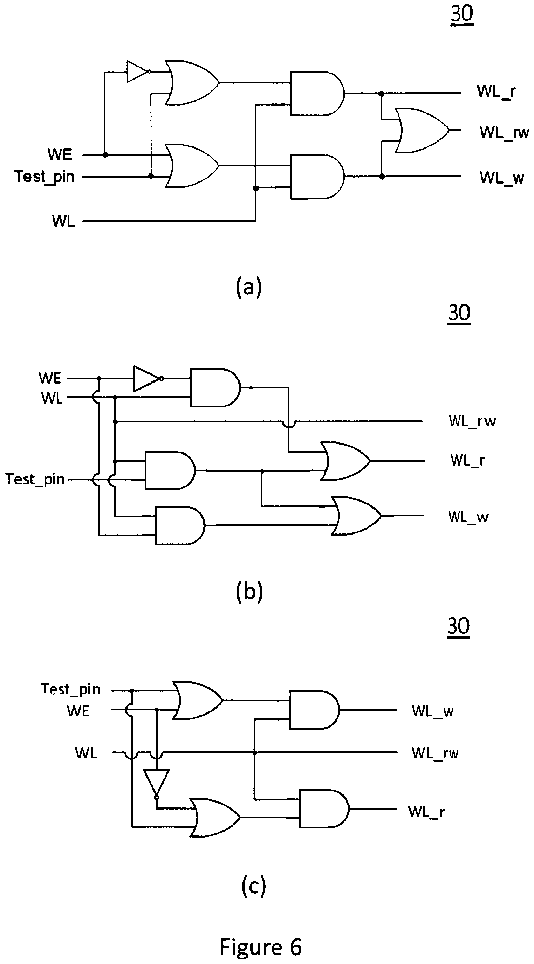

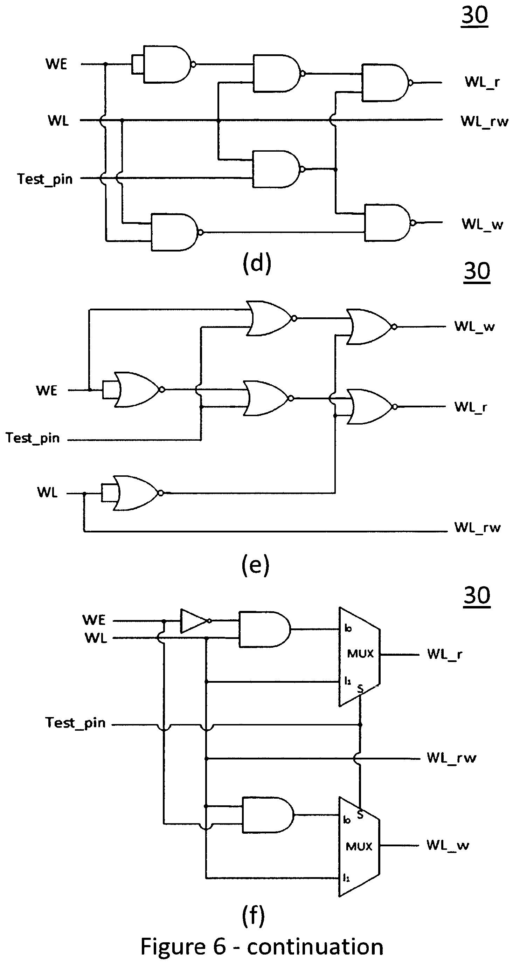

Based on the changes in the bit cell structure, its accessing mechanism also has to be modified. The demultiplexer of Figure 4(b) has to be replaced with a logic circuit that enables both read and write operations to be performed. **Figure 6** shows different examples of such a logic circuit 30, according to which read and write operations are simultaneously enabled only during testing after enabling the pin "test pin".

The logic circuit 30 has three control pins, namely the test pin, the write enable pin and the word line pin. From these three input pins, three output signals reaching the three output pins are derived. As explained with reference to Figure 3, the word line opens or closes the transistors in a row of the array of bit cells. Since the modified bit cell of Figure 5 has three transistors N1, N2 and N3, the control logic circuit 30 must be able to control the three transistors N1, N2 and N3 separately, according to which operation needs to be performed. Therefore the signal from the word line is "split" into three signals, one for each output pin connected to its respective transistor. The output pin WL_r is connected to all N3 transistors in a row of bit cells, the output pin WL_w is connected to all N1 transistors in a row of bit cells and the output pin WL_rw is connected to all N2 transistors in a row of bit cells.

Views (a) through (f) of Figure 6 show different possibilities for logically connecting the three input pins to the three output pins by means of logic gates such as AND, OR, NOT, NAND and NOR and other components such as multiplexers.

For example, in the control logic circuit of Figure 6(a) the WE signal and the test pin signal are the inputs of a first OR gate, and an inverted WE signal and the test pin signal are the inputs of a second OR gate. The output of the first OR gate and the WL signal are the inputs of a first AND gate and the output of the second OR gate and the WL signal are the inputs of a second AND gate. The output of the first AND gate goes to the output pin WL_w and the output of the second AND gate goes to the output pin WL_r. Further, the outputs of the first and second AND gates are the inputs of a third OR gate, whose output goes to the output pin WL_rw.

In the control logic circuit of Figure 6(b) the WE signal and the WL signal are the inputs of a first AND gate, an inverted WE signal and the WL signal are the inputs of a second AND gate and the WL signal and the test pin signal are the inputs of a third AND gate. The WL signal goes directly to the output pin WL_rw. The output of the first AND gate and the output of the third AND gate are the inputs of a first OR gate. The output of the second AND gate and the output of the third AND gate are the inputs of a second OR gate. The output of the first OR gate goes to the output pin WL_w and the output of the second OR gate goes to the output pin WL_r.

In the control logic circuit of Figure 6(c) the WE signal and the test pin signal are the inputs of a first OR gate, and an inverted WE signal and the test pin signal are the inputs of a second OR gate. The output of the first OR gate and the WL signal are the inputs of a first AND gate and the output of the second OR gate and the WL signal are the inputs of a second AND gate. The output of the first AND gate goes to the output pin WL_w and the output of the second AND gate goes to the output pin WL_r. Further, the WL signal goes directly to the output pin WL_rw.

In the control logic circuit of Figure 6(d) the WE signal provides both inputs for a first NAND gate, the WE signal and the WL signal are the inputs of a second NAND gate and the WL signal and the test pin signal are the inputs of a third NAND gate. The output of the first NAND gate and the WL signal are the inputs of a fourth NAND gate. The output of the second NAND gate and the output of the third NAND gate are the inputs of a fifth NAND gate, and the output of the fourth NAND gate and the output of the third NAND gate are the inputs of a sixth NAND gate. The output of the fifth NAND gate goes to the output pin WL_w and the output of the sixth NAND gate goes to the output pin WL_r. Further, the WL signal goes directly to the output pin WL_rw.

In the control logic circuit of Figure 6(e) the WE signal provides both inputs for a first NOR gate and the WL signal provides both inputs for a second NOR gate. The WE signal and the test pin signal are the inputs of a third NOR gate. The output of the first NOR gate and the test pin signal are the inputs of a fourth NOR gate. The output of the second NOR gate and the output of the third NOR gate are the inputs of a fifth NOR gate, and the output of the fourth NOR gate and the output of the second NOR gate are the inputs of a sixth NOR gate. The output of the fifth NOR gate goes to the output pin WL_w and the output of the sixth NOR gate goes to the output pin WL_r. Further, the WL signal goes directly to the output pin WL_rw.

In the control logic circuit of Figure 6(f) the WE signal and the WL signal are the inputs of a first AND gate and an inverted WE signal and the WL signal are the inputs of a second AND gate. The output of the first AND gate and the WL signal are the inputs of a first multiplexer and the output of the second AND gate and the WL signal are the inputs of a second multiplexer. The test pin signal is the selector input for both multiplexers. The output of the first multiplexer goes to the output pin WL_w and the output of the second multiplexer goes to the output pin WL_r. Further, the WL signal goes directly to the output pin WL_rw.

It should be noted that the configurations of Figure 6 are not exhaustive. The logic circuit 30 can assume any configuration that results in the following truth table:

**Table 3: Truth table for the logic circuit.**

| **Test_pin** | **WE** | **WL** | **WL_r** | **WL_w** | **WL_rw** | **Operation** |
|---|---|---|---|---|---|---|
| 0 | X | 0 | 0 | 0 | 0 | No operation |
| 0 | 1 | 1 | 0 | 1 | 1 | Write operation |
| 0 | 0 | 1 | 1 | 0 | 1 | Read operation |
| 1 | X | 1 | 1 | 1 | 1 | Read & write operation |

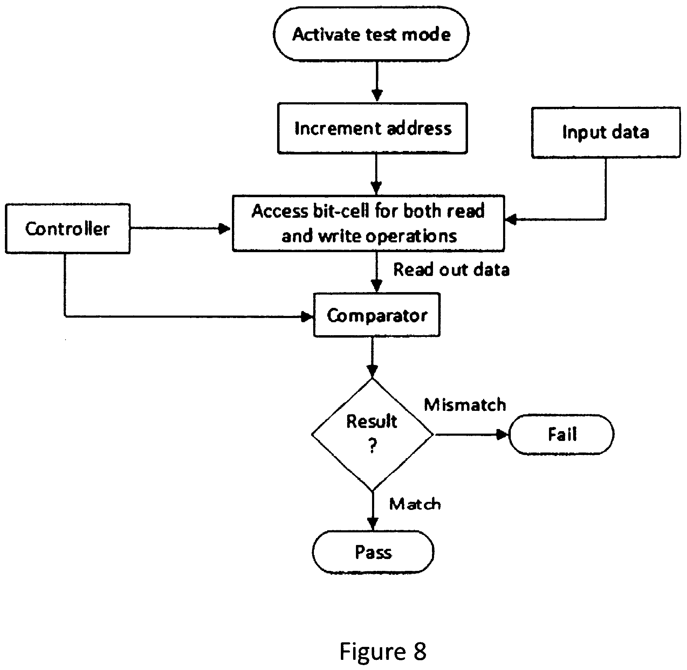

Table 3 above shows that, when the test pin is at a logical low level, i.e. the bit value is 0, normal memory operations can be performed. When and only when the test pin is at a logical high level, i.e. the bit value is 1, simultaneous read and write operations are enabled. The test pin is activated only during testing mode, thereby accelerating the testing procedure, as explained below with reference to Figure 8. The normal functioning of the bit cell is unaffected with this type of architecture as the enabling and disabling of simultaneous read-write processes is based on the test pin.

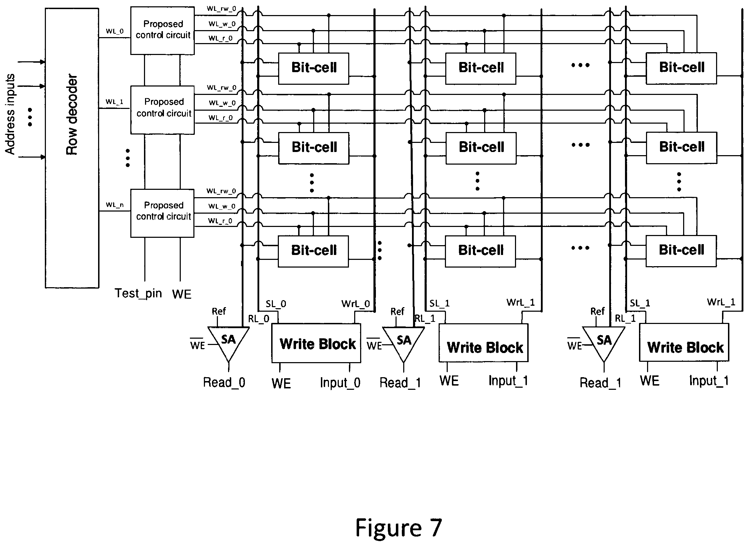

The complete architecture of the SOT-MRAM, in which simultaneous reading and writing is performed during the testing phase, is shown in **Figure 7****.** As already explained, the demultiplexers of Figure 4 are replaced with a control logic circuit 30 operating according to Table 3 above. Consequently, an additional word line, that connects the read-and-write access transistors, is introduced in the architecture of Figure 7 in comparison to the conventional architecture of Figure 4. Advantageously, this architecture can be used in combination with the MBIST environment shown in Figure 1, so that the new SOT-MRAM can be easily integrated with existing testing circuits.

The testing process is, however, different, namely more efficient in terms of time consumption. **Figure 8** shows a flow chart of a memory testing method in which read and write operations are performed simultaneously.

The testing mode is activated by activating the test pin and then a memory address is determined and sequenced to range from the minimum address to the maximum address (or vice versa) in the memory space. Once the address has been selected, a read-and-write operation is carried out for all bit cells according to the increasing or decreasing address order.

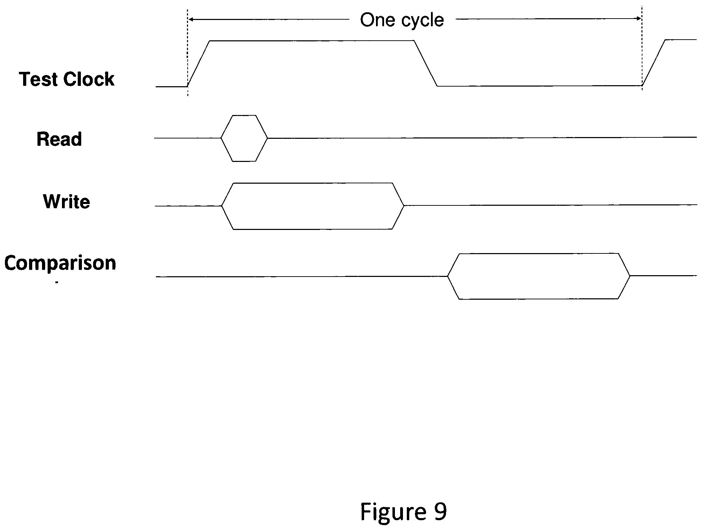

For each given address a bit value, i.e. input data, is stored into the bit cell corresponding to that address, wherein the bit value is also saved as expected data within the MBIST circuitry. In test mode, the read operation is performed in the same clock cycle as the write operation, on the same bit cell, and it reads the value that was previously stored therein. This can be seen in Figure 9, where the different operations are shown with respect to the clock cycle. As explained before, the read operation is performed much faster than the write operation. Therefore, during simultaneous read and write operations on the same bit cell, the previous bit value in the bit cell is always read first, before writing a new bit value. It follows that, when performing e.g. a march test according to the March-C pattern of Table 1, the first operation at step 1 is an individual (i.e. not simultaneous) write operation and the last operation at step 6 is an individual read operation. Instead, the read and write operations at steps 2 to 5 can be performed at the same time.

After the simultaneous access operation that includes both a read and a write operation, the read value is compared with the reference value of the expected data, which corresponds to the bit value written in the previous cycle, by a comparator module under control of the controller. In particular, as shown in Figure 9, the comparison operation is performed in the same clock cycle but in the following level of the clock cycle with respect to the read/write operation. If there is a mismatch between the read value and the written value, the MBIST detects a failure in the bit cell, which indicates a malfunctioning of the bit cell and, thus, of the memory. If there is a match between the read value and the written value, the MBIST determines that the bit cell functions correctly.

It can be seen that the accesses to the memory during test time, compared to the ones according to the conventional method of Figure 2, are simplified. Therefore, even when using existing testing circuitry such as MBIST circuitry, the testing procedure for an SOT-MRAM based on the modified bit cell and the logic circuit for accessing it can be significantly improved. Specifically, the testing procedure is faster because the write and read operations need not be performed sequentially but can instead be performed simultaneously during testing simply by activating the test pin.

### Circuit-level analysis

The results for the individual and simultaneous operations for the proposed design along with the standard design are summarize in Table 4 below. As shown in the table, the read latency and energy of the proposed individual operation are slightly increased compared to the standard design. This is due to the addition of the extra NMOS transistor in the modified bit cell of the proposed design. The read latency of the simultaneous operations is considerably higher than the individual read operations of both the standard bit cell and the modified bit cell. The reason therefor is that the write current, which is relatively high compared to the read current, slows the read process down. However, the modified bit cell only requires a single cycle for both read and write operation, so that the higher read latency is "masked" by the write latency, which is in any case longer.

Furthermore, the write latency and energy are the same for all three cases because the addition of a low read current for a very short duration has almost no impact on a high write current value. Actually, the read and write latencies are inversely proportional to their respective current values, which means that an increase in the current value can be used for the latency reduction for both read and write operations. In the implementation to which Table 4 refers both read and write latencies are optimized for the minimum energy consumption. However, these latencies can be further improved by passing higher current at the cost of more energy.

**Table 4: Design parameters for the standard bit cell and the modified bit cell.**

| Design parameters | | | Modified bit cell | |
|---|---|---|---|---|
| | | Standard bit cell | Individual operation | Simultaneous operation |
| Read | Latency (ps) | 28 | 30 | 46 |
| | Energy (fJ) | 0.26 | 0.34 | 31.44 |
| Write | Latency (ps) | 266 | 266 | 266 |
| | Energy (fJ) | 31.23 | 31.43 | 31.44 |
| # cycles required for a read and a write operation | | Two | One | |

## Claims

1. A memory circuit configured to increase the speed of memory test operations, the memory circuit comprising:
at least one bit cell (20) comprising a spin-orbit-torque magnetic tunnel junction (10) including two ferromagnetic layers (12, 16) and a metal electrode (18);
the memory circuit being **characterised by** further comprising three electronic switches (N1, N2, N3), wherein:
one ferromagnetic layer (12) has a fixed magnetic orientation and the other ferromagnetic layer (16) has a changeable magnetic orientation that is configured to be changed by a current flow through the metal electrode (18); and
the three electronic switches (N1, N2, N3) comprise a write access electronic switch (N1) configured to control the access to the bit cell (20) during write operations, a read access electronic switch (N3) configured to control the access to the bit cell (20) during read operations and a read-and-write access electronic switch (N2) configured to control the access to the bit cell (20) during both read and write operations;
and
at least one logic circuit (30) comprising three control pins, each pin configured to receive a single input signal, and a plurality of output pins, each output pin connected to a corresponding electronic switch of the three electronic switches (N1, N2, N3), wherein one of the three control pins is a test pin configured to enable or disable simultaneous read and write operations on the at least one bit cell (20), wherein simultaneous read and write operations are configured to be performed in the same clock cycle and the read access is faster than the write access so that the read operation reads a bit value stored in the at least one bit cell (20) by a previous write operation and not the bit value that is being written by the simultaneous write operation.

2. The memory circuit of claim 1, wherein the logic circuit (30) comprises logic gates configured such that all three output pins have a logical high level only when the test pin is activated.

3. The memory circuit of claim 2, wherein the test pin is activated only in a testing mode of the memory circuit.

4. The memory circuit of any one of claims 1 to 3, wherein the memory circuit comprises a plurality of bit cells (20) that are arranged in a two-dimensional array comprising rows and columns.

5. The memory circuit of claim 4, wherein the memory circuit comprises a plurality of logic circuits (30) and the number of logic circuits (30) is equal to the number of rows of the two-dimensional array.

6. A memory device comprising the memory circuit of any one of claims 1 to 5.

7. A random access memory of a computing device, such as a personal computer, a laptop computer, mobile phone, a tablet computer, or any such device, wherein the random access memory comprises the memory device of claim 6.

8. The memory device of claim 6, wherein the memory device is part of a system on a chip.

9. A computing device comprising one or more memory devices according to claim 6 or 8.

10. Use of the memory device of claim 6 as a memory in a computing device, wherein the memory circuit is in an operating mode in which the test pin is deactivated when used in the computing device.

11. A method for testing a spin-orbit-torque magnetic-tunnel-junction based memory circuit comprising at least one bit cell (20), the method being suitable to increase the speed of memory test operations and the method comprising:
- activating a test pin;
the method being **characterised by** further comprising:
- writing a first reference value to the at least one bit cell (20) comprising three electronic switches (N1, N2, N3);
- reading a first read bit value from the at least one bit cell (20);
- comparing the first read bit value with the first reference value;
- writing a second reference value to the at least one bit cell (20);
- reading a second read bit value from the at least one bit cell (20);
- comparing the second read bit value with the second reference value;
- if there is a match between the first read bit value and the first reference value and a match between the second read bit value and the second reference value, determining that the at least one bit cell (20) is faultless, or
- if there is not a match between the first read bit value and the first reference value or a match between the second read bit value and the second reference value, determining that the at least one bit cell (20) is faulty;
wherein the three electronic switches (N1, N2, N3) comprise a write access electronic switch (N1) configured to control the access to the bit cell (20) during write operations, a read access electronic switch (N3) configured to control the access to the bit cell (20) during read operations and a read-and-write access electronic switch (N2) configured to control the access to the bit cell (20) during both read and write operations, and wherein reading the first read bit value and writing the second reference value are performed simultaneously in that they are performed in the same clock cycle and the read access is faster than the write access so that the first read bit value is read while the first reference value, and not the second reference value that is being written simultaneously, is stored in the at least one bit cell (20).

12. The method of claim 11, further comprising storing the first reference value and the second reference value in an external storage.

13. The method of claim 11 or 12, further comprising:
- writing a third reference value to the at least one bit cell (20);
- reading a third read bit value from the at least one bit cell (20);
- comparing the third read bit value with the third reference value;
wherein reading the second read bit value and writing the third reference value are performed simultaneously,
wherein determining that the at least one bit cell (20) is faultless further requires that there is a match between the third read bit value and the third reference value, and
wherein determining that the at least one bit cell (20) is faulty further occurs if there is not a match between the third read bit value and the third reference value.

14. The method of any one of claims 11 to 13, further comprising:
selecting a memory address identifying the at least one bit cell (20) among a plurality of bit cells (20).

15. The method of any one of claims 11 to 14, wherein the memory circuit is part of a chip and the method is carried out before the chip is installed in a computing device, such as a mobile device, that stores data in the memory circuit.

## Patentansprüche

1. Speicherschaltung, die so ausgestaltet ist, dass die Geschwindigkeit von Speichertestvorgängen erhöht wird, wobei die Speicherschaltung umfasst:
mindestens eine Bitzelle (20), die einen magnetischen Spin-Orbit-Torque-Tunnelübergang (10) umfasst, der zwei ferromagnetische Schichten (12, 16) und eine Metallelektrode (18) umfasst;
wobei die Speicherschaltung **dadurch gekennzeichnet, ist, dass** sie ferner drei elektronische Schalter (N1, N2, N3) umfasst, wobei:
eine ferromagnetische Schicht (12) eine feste magnetische Ausrichtung aufweist und die andere ferromagnetische Schicht (16) eine veränderliche magnetische Ausrichtung aufweist, die so ausgestaltet ist, dass sie von einem Stromfluss durch die Metallelektrode (18) geändert werden kann; und
die drei elektronischen Schalter (N1, N2, N3) einen elektronischen Schreibzugriffsschalter (N1), der so ausgestaltet ist, dass er den Zugriff auf die Bitzelle (20) während Schreibvorgängen steuert, einen elektronischen Lesezugriffsschalter (N3), der so ausgestaltet ist, dass er den Zugriff auf die Bitzelle (20) während Lesevorgängen steuert, und einen elektronischen Lese- und Schreibzugriffsschalter (N2) umfassen, der so ausgestaltet ist, dass er den Zugriff auf die Bitzelle (20) während sowohl Lese- als auch Schreibvorgängen steuert;
und
mindestens eine Logikschaltung (30), die drei Steuerstifte, wobei jeder Stift so ausgestaltet ist, dass er ein einzelnes Eingangssignal empfängt, und eine Vielzahl von Ausgangsstiften umfasst, wobei jeder Ausgangsstift mit einem entsprechenden elektronischen Schalter der drei elektronischen Schalter (N1, N2, N3) verbunden ist, wobei einer der drei Steuerstifte ein Teststift ist, der so ausgestaltet ist, dass er gleichzeitige Lese- und Schreibvorgänge auf der mindestens einen Bitzelle (20) aktiviert oder deaktiviert, wobei gleichzeitige Lese- und Schreibvorgänge so ausgestaltet sind, dass sie im gleichen Taktzyklus durchgeführt werden und der Lesezugriff schneller als der Schreibzugriff ist, sodass der Lesevorgang einen durch einen vorhergehenden Schreibvorgang in der mindestens einen Bitzelle (20) gespeicherten Bitwert und nicht den Bitwert liest, der von dem gleichzeitigen Schreibvorgang geschrieben wird.

2. Speicherschaltung nach Anspruch 1, wobei die Logikschaltung (30) Logikgatter umfasst, die so ausgestaltet sind, dass alle drei Ausgangsstifte nur einen logisch hohen Pegel aufweisen, wenn der Teststift aktiviert ist.

3. Speicherschaltung nach Anspruch 2, wobei der Teststift nur in einem Testmodus der Speicherschaltung aktiviert ist.

4. Speicherschaltung nach einem der Ansprüche 1 bis 3, wobei die Speicherschaltung eine Vielzahl von Bitzellen (20) umfasst, die in einem zweidimensionalen Array angeordnet sind, das Zeilen und Spalten umfasst.

5. Speicherschaltung nach Anspruch 4, wobei die Speicherschaltung eine Vielzahl von Logikschaltungen (30) umfasst und die Anzahl der Logikschaltungen (30) gleich der Anzahl der Zeilen des zweidimensionalen Arrays ist.

6. Speichervorrichtung, die die Speicherschaltung nach einem der Ansprüche 1 bis 5 umfasst.

7. Direktzugriffsspeicher einer Rechenvorrichtung, wie beispielsweise eines Personal Computers, Laptop-Computers, Mobiltelefons, Tablet-Computers oder einer beliebigen solchen Vorrichtung, wobei der Direktzugriffsspeicher die Speichervorrichtung nach Anspruch 6 umfasst.

8. Speichervorrichtung nach Anspruch 6, wobei die Speichervorrichtung Teil eines System-on-a-Chip ist.

9. Rechenvorrichtung, die eine oder mehrere Speichervorrichtungen nach Anspruch 6 oder 8 umfasst.

10. Verwendung der Speichervorrichtung nach Anspruch 6 als ein Speicher in einer Rechenvorrichtung, wobei die Speicherschaltung sich in einem Betriebsmodus befindet, in dem der Teststift bei der Verwendung in der Rechenvorrichtung deaktiviert ist.

11. Verfahren zum Testen einer auf einem magnetischen Spin-Orbit-Torque-Tunnelübergang basierenden Speicherschaltung, die mindestens eine Bitzelle (20) umfasst, wobei das Verfahren sich zum Erhöhen der Geschwindigkeit von Speichertestvorgängen eignet und das Verfahren umfasst:
- Aktivieren eines Teststifts;
wobei das Verfahren **dadurch gekennzeichnet ist, dass** es ferner umfasst:
- Schreiben eines ersten Bezugswerts in die mindestens eine Bitzelle (20), die drei elektronische Schalter (N1, N2, N3) umfasst;
- Lesen eines ersten gelesenen Bitwerts von der mindestens einen Bitzelle (20);
- Vergleichen des ersten gelesenen Bitwerts mit dem ersten Bezugswert;
- Schreiben eines zweiten Bezugswerts in die mindestens eine Bitzelle (20);
- Lesen eines zweiten gelesenen Bitwerts von der mindestens einen Bitzelle (20);
- Vergleichen des zweiten gelesenen Bitwerts mit dem zweiten Bezugswert;
- wenn eine Übereinstimmung zwischen dem ersten gelesenen Bitwert und dem ersten Bezugswert und eine Übereinstimmung zwischen dem zweiten gelesenen Bitwert und dem zweiten Bezugswert vorhanden ist, Bestimmen, dass die mindestens eine Bitzelle (20) fehlerfrei ist, oder
- wenn keine Übereinstimmung zwischen dem ersten gelesenen Bitwert und dem ersten Bezugswert oder keine Übereinstimmung zwischen dem zweiten gelesenen Bitwert und dem zweiten Bezugswert vorliegt, Bestimmen, dass die mindestens eine Bitzelle (20) fehlerhaft ist;
wobei die drei elektronischen Schalter (N1, N2, N3) einen elektronischen Schreibzugriffsschalter (N1), der so ausgestaltet ist, dass er den Zugriff auf die Bitzelle (20) während Schreibvorgängen steuert, einen elektronischen Lesezugriffsschalter (N3), der so ausgestaltet ist, dass er den Zugriff auf die Bitzelle (20) während Lesevorgängen steuert, und einen elektronischen Lese- und Schreibzugriffsschalter (N2) umfassen, der so ausgestaltet ist, dass er den Zugriff auf die Bitzelle (20) während sowohl Lese- als auch Schreibvorgängen steuert, und
wobei das Lesen des ersten gelesenen Bitwerts und das Schreiben des zweiten Bezugswerts gleichzeitig durchgeführt werden, indem sie in dem gleichen Taktzyklus durchgeführt werden und der Lesezugriff schneller ist als der Schreibzugriff, sodass der erste gelesene Bitwert gelesen wird, während der erste Bezugswert und nicht der zweite Bezugswert, der gleichzeitig geschrieben wird, in der mindestens einen Bitzelle (20) gespeichert wird.

12. Verfahren nach Anspruch 11, das ferner das Speichern des ersten Bezugswerts und des zweiten Bezugswerts in einem externen Speicher umfasst.

13. Verfahren nach Anspruch 11 oder 12, ferner umfassend:
- Schreiben eines dritten Bezugswerts in die mindestens eine Bitzelle (20);
- Lesen eines dritten gelesenen Bitwerts aus der mindestens einen Bitzelle (20);
- Vergleichen des dritten gelesenen Bitwerts mit dem dritten Bezugswert;
wobei das Lesen des zweiten gelesenen Bitwerts und das Schreiben des dritten Bezugswerts gleichzeitig durchgeführt werden,
wobei das Bestimmen, dass die mindestens eine Bitzelle (20) fehlerfrei ist, ferner erfordert, dass eine Übereinstimmung zwischen dem dritten gelesenen Bitwert und dem dritten Bezugswert vorliegt, und
wobei das Bestimmen, dass die mindestens eine Bitzelle (20) fehlerhaft ist, ferner erfolgt, wenn keine Übereinstimmung zwischen dem dritten gelesenen Bitwert und dem dritten Bezugswert vorhanden ist.

14. Verfahren nach einem der Ansprüche 11 bis 13, ferner umfassend:
Auswählen einer Speicheradresse, die die mindestens eine Bitzelle (20) unter einer Vielzahl von Bitzellen (20) identifiziert.

15. Verfahren nach einem der Ansprüche 11 bis 14, wobei die Speicherschaltung Teil eines Chips ist und das Verfahren durchgeführt wird, bevor der Chip in einer Rechenvorrichtung, wie beispielsweise einer mobilen Vorrichtung, eingebaut wird, die Daten in der Speicherschaltung speichert.

## Revendications

1. Circuit de mémoire configuré pour augmenter la vitesse d'opérations de test de mémoire, le circuit de mémoire comportant :
au moins une cellule binaire (20) comportant une jonction de tunnel magnétique de couple d'orbite de rotation (10) incluant deux couches ferromagnétiques (12, 16) et une électrode métallique (18) ;
le circuit de mémoire étant **caractérisé en ce qu'**il comporte en outre trois commutateurs électroniques (N1, N2, N3), dans lequel :
une couche ferromagnétique (12) a une orientation magnétique fixe et l'autre couche ferromagnétique (16) a une orientation magnétique modifiable qui est configurée pour être modifiée par une circulation de courant à travers l'électrode métallique (18) ; et
les trois commutateurs électroniques (N1, N2, N3) comportent un commutateur électronique d'accès en écriture (N1) configuré pour commander l'accès à la cellule binaire (20) pendant des opérations d'écriture, un commutateur électronique d'accès en lecture (N3) configuré pour commander l'accès à la cellule binaire (20) pendant des opérations de lecture et un commutateur électronique d'accès en lecture et écriture (N2) configuré pour commander l'accès à la cellule binaire (20) pendant à la fois des opérations de lecture et d'écriture ;
et
au moins un circuit logique (30) comportant trois broches de commande, chaque broche étant configurée pour recevoir un signal d'entrée unique, et une pluralité de broches de sortie, chaque broche de sortie étant connectée à un commutateur électronique correspondant parmi les trois commutateurs électroniques (N1, N2, N3), dans lequel une des trois broches de commande est une broche de test configurée pour activer ou désactiver des opérations simultanées de lecture et d'écriture sur la au moins une cellule binaire (20), dans lequel des opérations simultanées de lecture et d'écriture sont configurées pour être exécutées dans le même cycle d'horloge, et l'accès en lecture est plus rapide que l'accès en écriture, de sorte que l'opération de lecture lise une valeur binaire stockée dans la au moins une cellule binaire (20) par une précédente opération d'écriture et non la valeur binaire qui est en cours d'écriture par l'opération d'écriture simultanée.

2. Circuit de mémoire selon la revendication 1, dans lequel le circuit logique (30) comporte des grilles logiques configurées de sorte que les trois broches de sortie aient toutes un niveau élevé logique uniquement lorsque la broche de test est activée.

3. Circuit de mémoire selon la revendication 2, dans lequel la broche de test est activée uniquement dans un mode de test du circuit de mémoire.

4. Circuit de mémoire selon l'une quelconque des revendications 1 à 3, dans lequel le circuit de mémoire comporte une pluralité de cellules binaires (20) qui sont agencées dans un réseau bidimensionnel comportant des rangées et des colonnes.

5. Circuit de mémoire selon la revendication 4, dans lequel le circuit de mémoire comporte une pluralité de circuits logiques (30) et le nombre de circuits logiques (30) est égal au nombre de rangées du réseau bidimensionnel.

6. Dispositif de mémoire comportant le circuit de mémoire selon l'une quelconque des revendications 1 à 5.

7. Mémoire à accès aléatoire d'un dispositif informatique, comme un ordinateur personnel, un ordinateur portable, un téléphone portable, une tablette ou tout autre dispositif de ce type, dans laquelle la mémoire à accès aléatoire comporte le dispositif de mémoire selon la revendication 6.

8. Dispositif de mémoire selon la revendication 6, dans lequel le dispositif de mémoire fait partie d'un système sur une puce.

9. Dispositif informatique comportant un ou plusieurs dispositifs de mémoire selon la revendication 6 ou 8.

10. Utilisation du dispositif de mémoire selon la revendication 6 en tant que mémoire dans un dispositif informatique, dans laquelle le circuit de mémoire est dans un mode de fonctionnement dans lequel la broche de test est désactivée lors d'une utilisation dans le dispositif informatique.

11. Procédé de test d'un circuit de mémoire à base de jonction de tunnel magnétique de couple d'orbite de rotation comportant au moins une cellule binaire (20), le procédé étant adapté pour augmenter la vitesse d'opérations de test de mémoire et le procédé comportant :
- l'activation d'une broche de test ;
le procédé étant **caractérisé en ce qu'**il comporte en outre :
- l'écriture d'une première valeur de référence sur la au moins une cellule binaire (20) comportant trois commutateurs électroniques (N1, N2, N3) ;
- la lecture d'une première valeur binaire lue à partir de la au moins une cellule binaire (20) ;
- la comparaison de la première valeur binaire lue à la première valeur de référence ;
- l'écriture d'une deuxième valeur de référence sur la au moins une cellule binaire (20) ;
- la lecture d'une deuxième valeur binaire lue à partir de la au moins une cellule binaire (20) ;
- la comparaison de la deuxième valeur binaire lue à la deuxième valeur de référence ;
- s'il existe une correspondance entre la première valeur binaire lue et la première valeur de référence et une correspondance entre la deuxième valeur binaire lue et la deuxième valeur de référence, la détermination que la au moins une cellule binaire (20) est sans défaillance ou
- s'il n'existe pas de correspondance entre la première valeur binaire lue et la première valeur de référence ou de correspondance entre la deuxième valeur binaire lue et la deuxième valeur de référence, la détermination que la au moins une cellule binaire (20) est défaillante ;
dans lequel les trois commutateurs électroniques (N1, N2, N3) comportent un commutateur électronique d'accès en écriture (N1) configuré pour commander l'accès à la cellule binaire (20) pendant des opérations d'écriture, un commutateur électronique d'accès en lecture (N3) configuré pour commander l'accès à la cellule binaire (20) pendant des opérations de lecture et un commutateur électronique d'accès en lecture et écriture (N2) configuré pour commander l'accès à la cellule binaire (20) pendant à la fois des opérations de lecture et d'écriture et
dans lequel la lecture de la première valeur binaire lue et l'écriture de la deuxième valeur de référence sont exécutées simultanément **en ce qu'**elles sont exécutées dans le même cycle d'horloge et que l'accès en lecture est plus rapide que l'accès en écriture, de sorte que la première valeur binaire lue soit lue tandis que la première valeur de référence, et non la deuxième valeur de référence qui est en cours d'écriture simultanément, soit stockée dans la au moins une cellule binaire (20).

12. Procédé selon la revendication 11, comportant en outre le stockage de la première valeur de référence et de la deuxième valeur de référence dans un stockage externe.

13. Procédé selon la revendication 11 ou 12, comportant en outre :
- l'écriture d'une troisième valeur de référence dans la au moins une cellule binaire (20) ;
- la lecture d'une troisième valeur binaire lue à partir de la au moins une cellule binaire (20) ;
- la comparaison de la troisième valeur binaire lue à la troisième valeur de référence ;
dans lequel la lecture de la deuxième valeur binaire lue et l'écriture de la troisième valeur de référence sont exécutées simultanément,
dans lequel la détermination que la au moins une cellule binaire (20) est sans défaillance exige en outre qu'il y ait une correspondance entre la troisième valeur binaire lue et la troisième valeur de référence et
dans lequel la détermination que la au moins une cellule binaire (20) est défaillante se produit en outre s'il n'y a pas de correspondance entre la troisième valeur binaire lue et la troisième valeur de référence.

14. Procédé selon l'une quelconque des revendications 11 à 13, comportant en outre :
la sélection d'une adresse mémoire identifiant la au moins une cellule binaire (20) parmi une pluralité de cellules binaires (20).

15. Procédé selon l'une quelconque des revendications 11 à 14, dans lequel le circuit de mémoire fait partie d'une puce et le procédé est réalisé avant que la puce ne soit installée dans un dispositif informatique, comme un dispositif mobile, qui stocke des données dans le circuit de mémoire.
